(19) Europäisches Patentamt
European Patent Office
Office européen des brevets

(11) EP 3 919 555 A1

(12) EUROPEAN PATENT APPLICATION
published in accordance with Art. 153(4) EPC

(43) Date of publication:
**08.12.2021 Bulletin 2021/49**

(21) Application number: **20748176.3**

(22) Date of filing: **31.01.2020**

(51) Int Cl.:
***C08K 7/00*** *(2006.01)* ***C08L 23/00*** *(2006.01)*

(86) International application number:
**PCT/JP2020/003620**

(87) International publication number:
**WO 2020/158913 (06.08.2020 Gazette 2020/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.01.2019 JP 2019015980**

(71) Applicant: **Sekisui Techno Molding Co., Ltd.**
**Tokyo 105-0003 (JP)**

(72) Inventors:
- **SUENAGA, Yuusuke**
  **Toyohashi-shi, Aichi 441-8123 (JP)**
- **MATSUMURA, Ryuuji**
  **Toyohashi-shi, Aichi 441-8123 (JP)**

(74) Representative: **Ter Meer Steinmeister & Partner Patentanwälte mbB**
**Nymphenburger Straße 4**
**80335 München (DE)**

# (54) RESIN MOLDED BODY

(57) Provided is a resin molded body capable of realizing both a high level of heat dissipation and a high level of flame retardancy at the same time. A resin molded body contains an olefin-based resin; an expandable graphite; and a plate graphite different from the expandable graphite, the expansion ratio of the expandable graphite being 50 ml/g or more and 600 ml/g or less, the content of the expandable graphite being 10 parts by weight or more and 300 parts by weight or less with respect to 100 parts by weight of the olefin-based resin, the volume mean particle size of the plate graphite being 30 μm or more and 500 μm or less, and the content of the plate graphite being 10 parts by weight or more and 300 parts by weight or less with respect to 100 parts by weight of the olefin-based resin.

EP 3 919 555 A1

## Description

### TECHNICAL FIELD

The present invention relates to a resin molded body.

### BACKGROUND ART

Metal plates, thermally conductive resin molded bodies, or the like have conventionally been used for housings of communication devices used outdoors or indoors, housings of electronic devices such as security cameras and smart meters, and other components such as a heat dissipation chassis, a heat sink for LED heat dissipation, and heat dissipation plates for SoC, GDC, etc. in car navigation systems, multi-information displays such as smart meters, and vehicle-mounted cameras. Note that, the terms "SoC" and "GDC" mean "System-on-a-Chip" and "Graphics Display Controller", respectively.
Such mechanical components are required to have a high level of flame retardancy as well as heat dissipation to efficiently dissipate the heat generated inside the device to the outside.
Patent Document 1 below discloses a thermoplastic resin composition that contains: 100 parts by mass of a thermoplastic resin; 10 to 200 parts by mass of a graphite; and 5 to 50 parts by mass of a flame retardant, in which a thermal conductivity as determined in accordance with JIS R 2618 is 1.0 W/m·K or more; and a flame retardant rating as determined by UL-94 standard is V-1 or higher. As an aforementioned flame retardant, a phosphate-based compound or the like is used. Also, there is a description that the resin composition disclosed in Patent Document 1 is excellent in thermal conductivity and flame retardancy.
Patent Document 2 below discloses a polyolefin resin composition containing 30 to 200 parts by mass of a heat conductive filler and 1 to 80 parts by mass of a flame retardant with respect to 100 parts by mass of the polyolefin-based resin. As an aforementioned flame retardant, there are described halogen-based flame retardants such as bromine-including flame retardants and antimony-containing flame retardants; and non-halogen-based flame retardants such as phosphates. Also, Patent Document 2 also discloses that such a polyolefin resin composition provide flame retardancy and heat dissipation.

### Related Art Document

### Patent Document

Patent Document 1: JP 2013-43949 A
Patent Document 2: JP 2015-189783 A

### SUMMARY OF THE INVENTION

### PROBLEMS TO BE SOLVED BY THE INVENTION

In recent years, an enhanced heat dissipation and an enhanced flame retardancy are needed more than before as CPU speed has been increased. However, the resin molded bodies disclosed in Patent Documents 1 and 2 have yet to be sufficient in their heat dissipation properties. Particularly, an attempt to enhance heat dissipation often results in reduced flame retardancy, thus, there have been a problem that a high level of heat dissipation and a high level of flame retardancy are difficult to be realized at the same time.
An object of the present invention is to provide a resin molded body capable of realizing both a high level of heat dissipation and a high level of flame retardancy at the same time.

### MEANS FOR SOLVING THE PROBLEMS

In a general aspect of a resin molded body according to the present invention, the resin molded body contains an olefin-based resin, an expandable graphite, and a plate graphite different from the expandable graphite, an expansion ratio of the expandable graphite being 50 ml/g or more and 600 ml/g or less, a content of the expandable graphite being 10 parts by weight or more and 300 parts by weight or less with respect to 100 parts by weight of the olefin-based resin, a volume mean particle size of the plate graphite being 30 μm or more and 500 μm or less, and a content of the plate graphite being 10 parts by weight or more and 300 parts by weight or less with respect to 100 parts by weight of the

olefin-based resin.

In another general aspect of a resin molded body according to the present invention, the resin molded body contains an olefin-based resin, an expandable graphite, and a plate graphite different from the expandable graphite, an expansion ratio of a mixture of the expandable graphite and the plate graphite being 10 ml/g or more and 500 ml/g or less, a volume mean particle size of the mixture of the expandable graphite and the plate graphite being 40 μm or more and 400 μm or less, a content of the expandable graphite being 10 parts by weight or more and 300 parts by weight or less with respect to 100 parts by weight of the olefin-based resin, and a content of the plate graphite being 10 parts by weight or more and 300 parts by weight or less with respect to 100 parts by weight of the olefin-based resin.

In a specific aspect of the resin molded body according to the present invention, a total content of the expandable graphite and the plate graphite is 50 parts by weight or more and 500 parts by weight or less with respect to 100 parts by weight of the olefin-based resin.

In another specific aspect of the resin molded body according to the present invention, a content ratio of the expandable graphite to the plate graphite (the expandable graphite/the plate graphite) is 0.05 or more and 0.5 or less.

In yet another specific aspect of the resin molded body according to the present invention, a flame retardant rating as determined in accordance with UL94 flammability standard is V1 or higher.

In still another specific aspect of the resin molded body according to the present invention, the resin molded body further contains a flame retardant having a primary particle size of 0.001 μm or more and 40 μm or less.

In still another specific aspect of the resin molded body according to the present invention, a content of the flame retardant is 5 parts by weight or more and 100 parts by weight or less with respect to 100 parts by weight of the olefin-based resin.

In still another specific aspect of the resin molded body according to the present invention, the resin molded body further contains an inorganic filler different from the expandable graphite and the plate graphite, the inorganic filler having a volume mean particle size of 0.001 μm or more and 40 μm or less.

In still another specific aspect of the resin molded body according to the present invention, a content of the inorganic filler is 5 parts by weight or more and 100 parts by weight or less with respect to 100 parts by weight of the olefin-based resin.

In still another specific aspect of the resin molded body according to the present invention, the resin molded body has a main surface, and a thermal conductivity in an in-plane direction along the main surface is 3 W/(m·K) or more.

In still another specific aspect of the resin molded body according to the present invention, the resin molded body is a heat dissipation chassis, a heat dissipation housing, or has a heat sink shape.

## EFFECT OF THE INVENTION

According to the present invention, there can be provided a resin molded body capable of realizing both a high level of heat dissipation and a high level of flame retardancy at the same time.

## BRIEF DESCRIPTION OF DRAWINGS

[FIG. 1] FIG. 1 is a schematic perspective view of a heat dissipation chassis.
[FIG. 2] FIG. 2 is a schematic perspective view of a heat dissipation housing.
[FIG. 3] FIG. 3 is a schematic perspective view of a heat sink shape.

## MODES FOR CARRYING OUT THE INVENTION

The details of the present invention will be described below.

According to the first invention of the present application, the resin molded body contains an olefin-based resin, an expandable graphite, and a plate graphite different from the expandable graphite. The expansion ratio of the expandable graphite is 50 ml/g or more and 600 ml/g or less. The content of the expandable graphite is 10 parts by weight or more and 300 parts by weight or less with respect to 100 parts by weight of the olefin-based resin. Additionally, the volume mean particle size of the plate graphite is 30 μm or more and 500 μm or less. The content of the plate graphite is 10 parts by weight or more and 300 parts by weight or less with respect to 100 parts by weight of the olefin-based resin.

According to the first invention of the present application, the resin molded body has the configuration as mentioned above, therefore, both a high level of heat dissipation and a high level of flame retardancy can be realized at the same time.

Conventional resin molded bodies may include a thermoplastic resin, a filler, and a flame retardant, but their heat dissipation properties have yet to be sufficient. Particularly, an attempt to enhance heat dissipation often results in

reduced flame retardancy, thus, there have been a problem that a high level of heat dissipation and a high level of flame retardancy are difficult to be realized at the same time. In addition, there is also a problem that, as a flame retardant, a halogen-based flame retardant or a phosphorus-based flame retardant is often used, which is environmentally unfavorable.

The present inventors have focused on the expansion ratio of the expandable graphite and the volume mean particle size of the plate graphite, and have found that both a high level of heat dissipation and a high level of flame retardancy can be realized at the same time by using the resin molded body which contains the expandable graphite and the plate graphite each in a specific ratio, the expandable graphite having the expansion ratio within a specific range, and the plate graphite having the mean particle size within a specific range.

According to the second invention of the present application, the resin molded body contains an olefin-based resin, an expandable graphite, and a plate graphite different from the expandable graphite. The mixture of the expandable graphite and the plate graphite has an expansion ratio of 10 ml/g or more and 500 ml/g or less. The mixture of the expandable graphite and the plate graphite has a volume mean particle size of 40 $\mu$m or more and 400 $\mu$m or less. The content of the expandable graphite is 10 parts by weight or more and 300 parts by weight or less with respect to 100 parts by weight of the olefin-based resin. Additionally, the content of the plate graphite is 10 parts by weight or more and 300 parts by weight or less with respect to 100 parts by weight of the olefin-based resin.

Since the resin molded body according to the second invention of the present application has the configuration as mentioned above, both a high level of heat dissipation and a high level of flame retardancy can be realized at the same time.

Conventional resin molded bodies may include a thermoplastic resin, a filler, and a flame retardant, but their heat dissipation properties have yet to be sufficient. Particularly, an attempt to enhance heat dissipation often results in reduced flame retardancy, thus, there have been a problem that a high level of heat dissipation and a high level of flame retardancy are difficult to be realized at the same time. In addition, there is also a problem that, as a flame retardant, a halogen-based flame retardant or a phosphorus-based flame retardant is often used, which is environmentally unfavorable.

The present inventors have focused on the expansion ratio of the mixture of the expandable graphite and the plate graphite; and the volume mean particle size of the mixture of the expandable graphite and the plate graphite, and have found that both a high level of heat dissipation and a high level of flame retardancy can be realized at the same time by using the resin molded body which contains the expandable graphite and the plate graphite each in a specific ratio, the mixture of the expandable graphite and the plate graphite having the expansion ratio within a specific range, and the mixture of the expandable graphite and the plate graphite having the volume mean particle size within a specific range.

Hereinafter, the first invention and the second invention of the present application may be collectively referred to as the invention of the present application.

Since the resin molded body of the present invention has a high level of heat dissipation, when it is used for a heat dissipation plate in a mechanical component of an electronic device, for example, the heat generated inside of the electronic device can be efficiently dissipated to the outside. Moreover, the resin molded body of the present invention can exhibit a high level of flame retardancy at the same time. Hence, the reliability of the electronic device can be enhanced.

In addition, since flame retardancy can be enhanced by using carbon materials such as the expandable graphite and/or the plate graphite, a high level of flame retardancy can be achieved even when a halogen-based flame retardant or a phosphorus-based flame retardant is not contained, or even when the addition of them is small. Hence, the resin molded body of the present invention can be preferably used from an environmental perspective as well.

Nevertheless, the resin molded body of the present invention may contain a flame retardant different from the expandable graphite and/or the plate graphite. By using a flame retardant in combination with the expandable graphite and/or the plate graphite, flame retardancy of the resin molded body can be further enhanced as compared with the case where a flame retardant is singly used.

In the present invention, the expansion ratio of the expandable graphite is 50 ml/g or more, preferably 80 ml/g or more, more preferably 150 ml/g or more, and 600 ml/g or less, preferably 500 ml/g or less, more preferably 350 ml/g or less. When the expansion ratio of the expandable graphite is the above-mentioned lower limit value or more, the flame retardancy of the resin molded body can be further enhanced. When the expandable graphite has the expansion ratio of the above-mentioned upper limit value or less, its dispersibility can be further enhanced at the time of being kneaded with the resin, and the moldability and the mechanical properties of the resin molded body can be further enhanced.

For example, the expansion ratio of the expandable graphite can be determined by the following method.

To begin with, the difference between the specific volume (ml/g) at room temperature and the specific volume (ml/g) after heating is determined. Into a quartz beaker preheated to 700°C in an electric furnace, 1 g of a thermal expandable material (expandable graphite) is added, immediately thereafter, the beaker is placed in the electric furnace, heated to 700°C, for 1 minute, and the beaker is taken out and is slowly cooled down to room temperature. Thereafter,

the apparent loose specific gravity (g/ml) of the expanded material is measured, the expansion ratio can be then calculated as the reciprocal of the apparent loose specific gravity: the expansion ratio = 1/the apparent loose specific gravity.

Additionally, the content of the expandable graphite is 10 parts by weight or more, preferably 20 parts by weight or more, more preferably 30 parts by weight or more, and 300 parts by weight or less, preferably 200 parts by weight or less, more preferably 100 parts by weight or less with respect to 100 parts by weight of the olefin-based resin. When the content of the expandable graphite is the above-mentioned lower limit value or more, the flame retardancy of the resin molded body can be further enhanced. When the content of the expandable graphite is the above-mentioned upper limit value or less, the surface quality of the resin molded body can be further enhanced, and the mechanical properties of the resin molded body can be further enhanced.

In the present invention, "a plate graphite different from the expandable graphite" is a plate graphite which has an expansion ratio less than 10 ml/g. As used herein, "plate graphite different from the expandable graphite" shall be simply referred to as "plate graphite" unless otherwise specified.

The volume mean particle size of the plate graphite is 30 μm or more, preferably 40 μm or more, more preferably 100 μm or more, further preferably 150 μm or more, and 500 μm or less, preferably 400 μm or less, more preferably 350 μm or less, still more preferably 300 μm or less. When the volume mean particle size of the plate graphite is the above-mentioned lower limit value or more, the heat dissipation of the resin molded body can be further enhanced. In addition, when the volume mean particle size of the plate graphite is the above-mentioned upper limit value or less, the flame retardancy of the resin molded body can be further enhanced. Note that, two or more types of the plate graphite having different volume mean particle sizes may be used in combination.

Furthermore, as used in the present invention, "a volume mean particle size of the plate graphite" refers to a value calculated from the volume-based distribution obtained by using a laser diffraction/scattering type particle size distribution measuring device on the basis of the laser diffraction method in accordance with JIS Z 8825: 2013.

More specifically, for example, the plate graphite is added to a soap aqueous solution (containing 0.01% of a neutral detergent) so that the plate graphite concentration becomes 2% by weight, then ultrasound at an output of 300 W is applied to the solution for 1 minute by using an ultrasonic homogenizer, to obtain a suspension. Next, the volume-based particle size distribution for the plate graphite in the suspension is measured by using a laser diffraction/scattering type particle size analyzer (manufactured by Nikkiso Co., Ltd., product name "Microtrac MT3300"). The volume mean particle size of the plate graphite can be calculated as 50% cumulative value of this volume-based particle size distribution.

In the present invention, the expansion ratio of the mixture of the expandable graphite and the plate graphite is preferably 50 ml/g or more, more preferably 100 ml/g or more, and preferably 350 ml/g or less, more preferably 300 ml/g or less, still more preferably 250 ml/g or less, particularly preferably 200 ml/g or less. When the expansion ratio of the mixture of the expandable graphite and the plate graphite is the above-mentioned lower limit value or more, the flame retardancy of the resin molded body can be further enhanced. When the mixture of the expandable graphite and the plate graphite has the expansion ratio of the above-mentioned upper limit value or less, its dispersibility can be further enhanced at the time of being kneaded with the resin, and the moldability and the mechanical properties of the resin molded body can be further enhanced. It should be noted that, when two or more types of the plate graphite having different volume mean particle sizes are used in combination, the expansion ratio is defined as the expansion ratio of the mixture of the expandable graphite and two or more types of the plate graphite.

In the present invention, the volume mean particle size of the mixture of the expandable graphite and the plate graphite is preferably 60 μm or more, more preferably 100 μm or more, and preferably 350 μm or less, more preferably 300 μm or less, still more preferably less than 300 μm, particularly preferably 250 μm or less. When the volume mean particle size of the mixture of the expandable graphite and the plate graphite is the above-mentioned lower limit or more, the heat dissipation of the resin molded body can be further enhanced. In addition, when the volume mean particle size of the mixture of the expandable graphite and the plate graphite is the above-mentioned upper limit value or less, the flame retardancy of the resin molded body can be further enhanced. It should be noted that, when two or more types of the plate graphite having different volume mean particle sizes are used in combination, the volume mean particle size is defined as the volume mean particle size of the mixture of the expandable graphite and two or more types of the plate graphite.

For example, the volume mean particle size of the mixture of the expandable graphite and the plate graphite may be determined as follows: a test piece cut out from a resin molded body is heated at a temperature of 600°C to remove the resin, whereby a mixture of the expandable graphite and the plate graphite is extracted, which should be used for the aforementioned methods for the measurement of the expansion ratio and the volume mean particle size.

For example, the expansion ratio of the mixture of the expandable graphite and the plate graphite can be determined as follows. To 1.5 g of a test piece cut out from a resin molded body, 1000 ml of an ortho-dichlorobenzene (o-DCB) solution containing dibutyl hydroxytoluene (BHT) (BHT: o-DCB = 50 : 50 (in weight ratio)) is added to obtain a mixed solution. Next, using a dissolution filtration device (e.g., trade name "DF-8020" manufactured by TOSHO), the mixed solution is shaken for 2 hours under the settings: the mixed solution temperature of 145°C; and the rotation speed of 25 rpm, thereby dissolving all the olefin-based resins to remove the resin. Thus, a mixture of the expandable graphite

and the plate graphite are extracted, which should be used for the measurement of the expansion ratio in accordance with the aforementioned method.

The content of the plate graphite is 10 parts by weight or more, preferably 70 parts by weight or more, more preferably 100 parts by weight or more, and 300 parts by weight or less, preferably 200 parts by weight or less, more preferably 150 parts by weight or less with respect to 100 parts by weight of the olefin-based resin. When the content of the plate graphite is the above-mentioned lower limit value or more, the heat dissipation of the resin molded body can be further enhanced. When the content of the plate graphite is the above-mentioned upper limit value or less, the dispersibility of the plate graphite can be further enhanced at the time of being kneaded with the resin, and the moldability and the mechanical properties of the resin molded body can be further enhanced.

In the present invention, the total content of the expandable graphite and the plate graphite is preferably 50 parts by weight or more, more preferably 100 parts by weight or more, still more preferably 150 parts by weight or more, and preferably 500 parts by weight or less, more preferably 300 parts by weight or less with respect to 100 parts by weight of the olefin-based resin. When the total content of the expandable graphite and the plate graphite is the above-mentioned lower limit values or more, the heat dissipation and the flame retardancy of the resin molded body can be further enhanced. When the total content of the expandable graphite and the plate graphite is the above-mentioned upper limit values or less, the dispersibility of the expandable graphite and the plate graphite can be further enhanced at the time of being kneaded with the resin, and the moldability and the mechanical properties of the resin molded body can be further enhanced.

In the present invention, the content ratio of the expandable graphite to the plate graphite (the expandable graphite/the plate graphite) is preferably 0.05 or more, more preferably 0.1 or more, and preferably 0.5 or less, more preferably 0.3 or less. When the content ratio (the expandable graphite/the plate graphite) is the above-mentioned lower limit value or more, the flame retardancy of the resin molded body can be further enhanced. When the content ratio is the above-mentioned upper limit value or less, the heat dissipation of the resin molded body can be further enhanced.

In the present invention, the flame retardant rating of the resin molded body as determined in accordance with the flammability standard UL94 is preferably V1 or higher, more preferably V0 or higher. In this case, the flame retardancy of the resin molded body can be further enhanced.

In the present invention, a thermal conductivity in an in-plane direction along a main surface of the resin molded body is preferably 3 W/ (m·K) or more, more preferably 8 W/(m·K) or more, still more preferably 10 W/(m·K) or more, particularly preferably 15 W/ (m·K) or more, most preferably 20 W/ (m·K) or more. The upper limit of the thermal conductivity in the in-plane direction is not particularly limited, but for example, it is 50 W/ (m·K).

It should be noted that, the main surface may be a flat surface or a curved surface. Additionally, as used in the present invention, the term "main surface" refers to a continuous surface having the largest area among the plurality of surfaces on the exterior of the resin molded body.

Thermal conductivity in the in-plane direction can be calculated by using the following equation (1).

Thermal conductivity (W/(m·K)) = specific gravity (g/cm$^3$) $\times$ specific heat (J/g K) $\times$ thermal diffusivity (mm$^2$/s) ... Equation (1)

Thermal diffusivity can be measured, for example, by using the product number "Xenon flash laser analyzer LFA467 HyperFlash" manufactured by NETZSCH Japan K.K.

The resin molded body of the present invention is a molded body of a resin composition which contains a polyolefin-based resin, an expandable graphite, and a plate graphite. The resin molded body of the present invention can be obtained by molding the resin composition in a method such as press working, extrusion processing, extrusion laminating processing, or injection molding.

The resin molded body of the present invention is excellent in both heat dissipation and flame retardancy. Hence, the resin molded body of the present invention can be preferably used, for example, in housings of communication devices used outdoors or indoors, or housing of electronic devices such as security cameras or smart meters. Alternatively, it can be preferably used for a heat dissipation chassis, a heat sink such as a heat sink for LED heat dissipation, and heat dissipation plates for SoC, GDC, etc. in car navigation systems, multi-information displays such as smart meters, and vehicle-mounted cameras.

The resin molded body of the present invention is preferably a heat dissipation chassis, a heat dissipation housing, or has a heat sink shape. Specific examples of a heat dissipation chassis, a heat dissipation housing, and a heat sink shape will be described below with reference to FIGS. 1 to 3.

FIG. 1 is a schematic view of a heat dissipation chassis. When the resin molded body is a heat dissipation chassis, its main surface is the portion indicated by arrow A in FIG. 1.

FIG. 2 is a schematic view of a heat dissipation housing. When the resin molded body is a heat dissipation housing, its main surface is the portion indicated by arrow B in FIG. 2. Note that, as shown in FIGS. 1 and 2, the main surface may have unevenness.

FIG. 3 is a schematic view of a heat sink shape. When the resin molded body has a heat sink shape, the main surfaces are the portion indicated by arrow C in FIG. 3. Specifically, a main surface on one side of the bottom plate

portion and surfaces of fin portions are the main surface. In this way, multiple main surfaces may be present.

Note that, a circuit may be formed on a surface of such a resin molded body.

Details of the materials constituting the resin molded body of the present invention will be described below.

(Olefin-based resins)

The resin molded body of the present invention contains an olefin-based resin. Olefin-based resins are not particularly limited, and known polyolefins can be used. Specific examples of polyolefins include polyethylene-based resins such as: polyethylene, which is the homopolymer of ethylene; ethylene-α-olefin copolymer; ethylene-(meth)acrylic acid copolymer; ethylene-(meth)acrylate copolymer; and ethylene-vinyl acetate copolymer. Examples of polyolefins may also include: polypropylene-based resins such as polypropylene, which is the homopolymer of propylene, propylene-α-olefin copolymer; polybutene, which is the homopolymer of butene; and a homopolymer or a copolymer of a conjugated diene such as butadiene or isoprene. These polyolefins may be used alone, or a plurality of them may be used in combination. In view of further enhancement of heat resistance and elastic modulus, a preferable polyolefin is polypropylene.

In addition, polyolefin (olefin-based resin) preferably contains an ethylene component. The content of the ethylene component is preferably 5% by mass to 40% by mass. When the content of the ethylene component is within the above range, the heat resistance of the resin molded body can be further enhanced, while its impact resistance being further enhanced.

(Expandable graphite)

The resin molded body of the present invention contains an expandable graphite. An expandable graphite is not particularly limited, and conventionally known products can be used. As an expandable graphite, for example, there can be used a product of a graphite intercalation compound produced by treating powders such as: natural vein graphite; thermally decomposed graphite; or kish graphite, with an inorganic acid such as: concentrated sulfuric acid; nitric acid; or selenic acid, along with a strong oxidizing agent such as: concentrated nitric acid; perchloric acid; perchlorate; permanganate; dichromate; or hydrogen peroxide. Thus, a preferable expandable graphite is a crystalline compound that retains the layer structure of graphite.

An expandable graphite may be a neutralized product of the expandable graphite produced by the acid treatment, which is followed by neutralization with ammonia, an aliphatic lower amine, an alkali metal compound, an alkaline earth metal compound, or the like.

Examples of aliphatic lower amines include: monomethylamine, dimethylamine, trimethylamine, ethylamine, propylamine, and butylamine.

Examples of alkali metal compounds and alkaline earth metal compounds include: hydroxides; oxides; carbonates; sulfates; and organic acid salts of each of potassium; sodium; calcium; barium; magnesium; and the like.

Specific examples of such expandable graphite include "CA-60S" manufactured by Nippon Kasei Chemical Co., Ltd.

The volume mean particle size of the expandable graphite is preferably 40 μm or more, more preferably 100 μm or more, still more preferably 150 μm or more, and preferably 800 μm or less, more preferably 500 μm or less, still more preferably 350 μm or less. When the volume mean particle size of the expandable graphite is the above-mentioned lower limit value or more, the expansion ratio can be further increased, and the heat dissipation and the flame retardancy can be further enhanced. When the expandable graphite has the volume mean particle size of the above-mentioned upper limit value or less, its dispersibility can be further enhanced at the time of being kneaded with the resin, and the moldability and the mechanical properties of the resin molded body can be further enhanced. It should be noted that the volume mean particle size of the expandable graphite can be measured by the same method as that of measuring the volume mean particle size of the plate graphite.

(Plate graphite)

The resin molded body of the present invention contains a plate graphite different from the expandable graphite. Plate graphite may be any graphite that has a plate-like shape. For example, graphite, flaked graphite, graphene, or the like, can be used. In view of further enhancement of heat dissipation and flame retardancy, a preferable plate graphite is graphite or flaked graphite. These may be used alone, or a plurality of them may be used in combination. Note that the graphite may be a crystalline graphite.

The term "flaked graphite" refers to a stack of graphene sheets which has a smaller thickness than original graphite, and is a product obtained by flaking of the original graphite. Flaking process to form flaked graphite is not particularly limited, and there may be employed either a mechanical flaking process using a supercritical fluid or the like,

or a chemical flaking process using an acid. The number of layers of stacked graphene sheets in the flaked graphite may be any number smaller than that of the original graphite, but is preferably 1000 layers or less, more preferably 500 layers or less, and further preferably 200 layers or less.

An aspect ratio of the plate graphite is preferably 5 or more, more preferably 21 or more, and preferably 2000 or less, more preferably 1000 or less, still more preferably 100 or less. When an aspect ratio of the plate graphite is the above-mentioned lower limit or more, the heat dissipation in the plane direction can be further enhanced. When an aspect ratio of the plate graphite is the above-mentioned upper limit or less, the graphite particles themselves are further unlikely to be bent in the olefin-based resin at the time of injection molding. Hence, gas barrier performance can be further enhanced and flame retardancy can be further enhanced. Note that, as used herein, the term "aspect ratio" refers to the ratio of the maximum size of a plate graphite along the direction of the stacked layer plane to the thickness of the plate graphite.

It should be noted that, the shape and the thickness of plate graphite can be measured by using, for example, a transmission electron microscope (TEM) or a scanning electron microscope (SEM). In view of further convenience of observation, it is preferable that a test piece cut out from a resin molded body should be heated at 600°C thereby to remove the resin in advance of an observation using a transmission electron microscope (TEM) or a scanning electron microscope (SEM). Note that, a test piece may be cut out along the direction parallel to the main surface of the resin molded body, or may be cut out along the direction perpendicular to the main surface of the resin molded body, as long as the resin can be removed and the thickness of the plate graphite can be measured.

(Flame retardants)

The resin molded body of the present invention may further contain another flame retardant. Other flame retardants include, but are not particularly limited, bromine compounds, phosphorus compounds, chlorine compounds, antimony compounds, metal hydroxides, nitrogen compounds, boron compounds. These may be used alone, or a plurality of them may be used in combination.

In view of further enhancement of flame retardancy, at least one of a halogen-based flame retardant or a phosphorus-based flame retardant is preferably contained as a flame retardant. In particular, a phosphorus-based flame retardant is preferably used for further effective prevention of charring caused by gas generation during molding.

The content of the flame retardant is not particularly limited, but for example, is preferably 5 parts by weight or more and 100 parts by weight or less with respect to 100 parts by weight of the olefin-based resin. When the content of flame retardant is the above-mentioned lower limit value or more, the flame retardancy of the resin molded body can be further enhanced. Moreover, when the content of the flame retardant is the above-mentioned upper limit value or less, the heat dissipation of the resin molded body can be further enhanced.

The primary particle size of the flame retardant is preferably 0.001 μm or more, more preferably 0.01 μm or more, still more preferably 0.1 μm or more, particularly preferably 1 μm or more, and preferably 40 μm or less, more preferably 30 μm or less, still more preferably 20 μm or less.

Particularly, in the present invention, a plate graphite having a volume mean particle size of 40 μm or more and 500 μm or less, and a flame retardant having a primary particle size of 0.001 μm or more and 40 μm or less are used in combination, whereby the flame retardancy can be further enhanced while further suppressing the reduction of the heat dissipation. Note that, a primary particle size of a flame retardant is an average of primary particle sizes of the flame retardant determined with use of its image data obtained by a transmission electron microscope, for example. For example, as a transmission electron microscope, the product name "JEM-2200FS" manufactured by JEOL Ltd. can be used.

Halogen-based flame retardants are not particularly limited, and examples thereof include low molecular weight bromine-containing compounds, halogenated polymers, and halogenated oligomers. One of them may be used alone, or a plurality of them may be used in combination.

Examples of low molecular weight bromine-containing compounds include: perchloropentacyclodecane, hexabromobenzene, pentabromotoluene, hexabromobiphenyl, decabromobiphenyl, hexabromocyclodecane, decabromodiphenyl ether, octabromodiphenyl ether, hexabromodiphenyl ether, bis(pentabromophenoxy) ethane, ethylene bis-(tetrabromophthalimide), and tetrabromobisphenol A.

Examples of halogenated polymers and halogenated oligomers include: brominated polycarbonate, brominated epoxy compounds, brominated phenoxy compounds, poly(brominated benzyl acrylate), brominated polyphenylene ether, and brominated bisphenol A/chlorinated cyanul/brominated phenol condensate.

In addition, an antimony oxide as a flame retardant auxiliary is preferably used in combination with halogen-based flame retardant. Antimony oxides are not particularly limited, and examples thereof include; antimony trioxide; and antimony pentoxide. One of them may be used alone, or a plurality of them may be used in combination.

The content of the antimony oxide as a flame retardant auxiliary is not particularly limited, but is preferably 1 part by weight or more, more preferably 20 parts by weight or more, and preferably 200 parts by weight or less, more

preferably 100 parts by weight with respect to 100 parts by weight of the halogen-based flame retardant. In particular, an addition in a ratio of one antimony atom to 2 to 5 halogen atoms of the halogen-based flame retardant is particularly preferable.

Phosphorus-based flame retardants are not particularly limited, and examples thereof include: phosphorus compounds represented by the following general formula (1); red phosphorus; and ammonium polyphosphate. One of them may be used alone, or a plurality of them may be used in combination.

[Chemical 1]

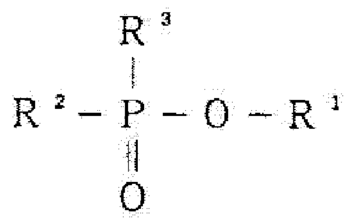

... Formula (1)

In the general formula (1), $R^1$ and $R^3$ may be the same or different. $R^1$ and $R^3$ each represents hydrogen, a linear or branched alkyl group having 1 to 16 carbon atoms, or an aryl group having 6 to 16 carbon atoms. $R^2$ represents a hydroxyl group, a linear or branched alkyl group having 1 to 16 carbon atoms, a linear or branched alkoxyl group having 1 to 16 carbon atoms, an aryl group having 6 to 16 carbon atoms, or an aryloxy group having 6 to 16 carbon atoms.

The compounds represented by the general formula (1) are not particularly limited, and examples thereof include: methylphosphonic acid, dimethyl methylphosphonate, diethyl methylphosphonate, ethylphosphonic acid, n-propylphosphonic acid, n-butylphosphonic acid, 2-methylpropylphosphonic acid, t-butylphosphonic acid, 2,3-dimethyl-butylphosphonic acid, octylphosphonic acid, phenylphosphonic acid, dioctyl phenylphosphonate, dimethylphosphinic acid, methylethylphosphinic acid, methylpropylphosphinic acid, diethylphosphinic acid, dioctylphosphinic acid, phenylphosphinic acid, diethylphenylphosphinic acid, diphenylphosphinic acid, and bis(4-methoxyphenyl) phosphinic acid. In particular, t-butylphosphonic acid, although it is expensive, can further enhance flame retardancy. Additionally, one of them may be used alone, or a plurality of them may be used in combination.

A red phosphorus is not particularly limited, and a commercially available red phosphorus can be used. However, in view of further enhancement of moisture resistance and further enhancement of safety such as the prevention of spontaneous combustion at the time of being kneaded, there can be preferably used a product such as red phosphorus particles whose surfaces are coated with ammonium polyphosphate resins.

(Inorganic fillers)

The resin molded body of the present invention may further contain an inorganic filler. Inorganic fillers are not particularly limited, and examples thereof include: metal oxides, metal hydroxides, metal carbonates, calcium salts, silica, diatomite, dawsonite, barium sulfate, talc, clay, mica, montmorillonite, bentonite, active white clay, sepiolite, imogolite, sericite, glass fiber, glass beads, silica balloon, aluminum nitride, boron nitride, silicon nitride, carbon black, graphite, carbon fiber, carbon balloon, charcoal powder, various metal powders, potassium titanate, magnesium sulfate, lead zirconate titanate, zinc stearate, calcium stearate, aluminum borate, molybdenum sulfide, silicon carbide, stainless steel fibers, zinc borate, various magnetic powders, slag fibers, fly ash, and dehydrated sludge. One of them may be used alone, or a plurality of them may be used in combination.

Examples of metal oxides include: alumina, zinc oxide, titanium oxide, calcium oxide, magnesium oxide, iron oxide, tin oxide, antimony oxide, and ferrite.

Examples of metal hydroxides include: calcium hydroxide, magnesium hydroxide, aluminum hydroxide, and hydrotalcite.

Examples of metal carbonates include: basic magnesium carbonate, calcium carbonate, magnesium carbonate, zinc carbonate, strontium carbonate, and barium carbonate.

Examples of calcium salts include: calcium sulfate, gypsum fiber, and calcium silicate.

A volume mean particle size of the inorganic filler is preferably 0.001 μm or more, more preferably 0.01 μm or more, still more preferably 0.1 μm or more, particularly preferably 1 μm or more, and preferably 40 μm or less, more preferably 10 μm or less, still more preferably 1 μm or less.

Particularly, in the present invention, a plate graphite having a volume mean particle size of 30 μm or more and 500 μm or less are combined with an inorganic filler having a volume mean particle size of 0.001 μm or more and

40 μm or less, whereby flame retardancy can be further enhanced while further suppressing the reduction of heat dissipation. Note that, the volume mean particle size of the inorganic filler can be measured by the same method as that of measuring the volume mean particle size of the plate graphite.

The content of the inorganic filler is not particularly limited, but for example, is preferably 5 parts by weight or more and 100 parts by weight or less with respect to 100 parts by weight of the olefin-based resin. When the content of the inorganic filler is the above-mentioned lower limit value or more, the flame retardancy of the resin molded body can be further enhanced. When the content of the inorganic filler is the above-mentioned upper limit value or less, the dispersibility of the inorganic filler can be further enhanced at the time of being kneaded with the resin, and the moldability and the mechanical properties of the resin molded body can be further enhanced.

(Fiber-based fillers)

The resin molded body of the present invention may further contain a fiber-based filler. Examples of the fiber-based fillers include: metal fibers, carbon fibers, cellulose fibers, aramid fibers, and glass fibers. One of them may be used alone, or a plurality of them may be used in combination.

The content of the fiber-based filler is not particularly limited, but is preferably 1 part by weight or more and 200 parts by weight or less with respect to 100 parts by weight of the polyolefin-based resin. When the content of the fiber-based filler is within the above range, more excellent fluidity can be imparted to the resin composition at the time of forming the resin molded body.

Carbon fibers are not particularly limited, but PAN-based or pitch-based carbon fibers or the like can be used.

(Other additives)

The resin molded body of the present invention may further contain various additives as optional components. Examples of additives include: antioxidants such as phenol-based, phosphorus-based, amine-based, or sulfur-based antioxidants; ultraviolet absorbers such as benzotriazole-based, or hydroxyphenyltriazine-based ultraviolet absorbers; metal damage inhibitors; various fillers; antistatic agents; stabilizers; and pigments. One of them may be used alone, or a plurality of them may be used in combination.

One exemplified method of producing the resin molded body of the present invention will be described below.

(Method of producing resin molded body)

For example, the resin molded body of the present invention can be produced according to the method set forth below.

First, there is prepared a resin composition containing a polyolefin-based resin, an expandable graphite, and a plate graphite. The resin composition may further contain various materials described above. In the resin composition, the expandable graphite is preferably dispersed in the polyolefin-based resin. In this case, the flame retardancy of the resulting resin molded body can be further enhanced. The method of dispersing the expandable graphite and/or the plate graphite in the polyolefin-based resin is not particularly limited, but even more uniform dispersion can be realized by using heat-melting of the polyolefin-based resin at the time of being kneaded with the expandable graphite and/or the plate graphite.

The kneading methods mentioned above are not particularly limited, but an exemplified method is a method in which kneading is carried out on heating, with use of a kneading machine: a twin-screw kneader such as a plast mill; a single-screw extruder; a twin-screw extruder; a banbury mixer; a roll; or a pressure kneader. Among these, a method of melt-kneading with use of pressure kneader is preferable.

Next, the prepared resin composition can be molded, for example, with a method such as press working, extrusion processing, extrusion laminating processing, or injection molding to give a resin molded body.

In this way, in the resin molded body of the present invention, its physical properties can be appropriately adjusted for its intended use.

In the following description, the effects of the present invention will be clarified with specific examples of the present invention and comparative examples. It should be noted that the present invention is not limited to the following examples.

(Example 1)

One hundred parts by weight of polypropylene (PP) as an olefin-based resin, 10 parts by weight of expandable graphite, and 100 parts by weight of crystalline graphite as a plate graphite were melt-kneaded at 180°C using LABO PLASTOMILL (manufactured by Toyo Seiki Seisaku-sho, Ltd., product number "R100") to give a resin composition. The

resultant resin composition was injection-molded at the resin composition temperature of 180°C and the mold temperature of 40°C, thereby obtaining a resin molded body with a length of 100 mm, a width of 100 mm, and a thickness of 2 mm. Note that, the trade name "BC10HRF" manufactured by Japan Polypropylene Corporation was used as a polypropylene. The trade name "EXP-80S220" (expansion ratio: 200 ml/g, volume mean particle size: 180 μm) manufactured by Fujikokuen Co., Ltd., was used as an expandable graphite. The trade name "CPB-100" (volume mean particle size: 100 μm) manufactured by Chuetsu Graphite Works Co., Ltd., was used as a crystalline graphite.

Additionally, a test piece cut out from the resultant resin molded body was heated at 600°C to remove the resin, and a mixture of the plate graphite and the expandable graphite was extracted and was used for its volume mean particle size measurement set forth below.

The volume mean particle size measurement was conducted based on the particle size analysis-laser diffraction/scattering method in accordance with JIS Z 8825. Specifically, the mixture as obtained above was added to a soap aqueous solution (neutral detergent content: 0.01%) so that the mixture concentration becomes 2% by weight, then ultrasound at an output of 300 W was applied to the solution for 1 minute by using an ultrasonic homogenizer, whereby a suspension was obtained. Next, the suspension was measured for the volume-based particle size distribution of the mixture by using a laser diffraction/scattering type particle size analyzer (manufactured by NIKKISO CO., LTD., product name "Microtrac MT3300"), and the average of volume particle sizes of the mixture was calculated as 50% cumulative value of this volume-based particle size distribution. Note that, the same method was used in Examples and Comparative Examples set forth below.

Furthermore, to 1.5 g of a test piece cut out from the resin molded body, 1000 ml of an ortho-dichlorobenzene (o-DCB) solution containing dibutyl hydroxytoluene (BHT) (BHT: o-DCB = 50 : 50 (in weight ratio)) was added to give a mixed solution. Next, the mixed solution was shaken for 2 hours using a dissolution filtration device (e.g., trade name "DF-8020" manufactured by TOSHO) under the settings: mixed solution temperature of 145°C; rotation speed of 25 rpm, thereby dissolving all olefin-based resins to remove the resin. Thus, the mixture of the expandable graphite and the plate graphite was extracted and was used for its expansion ratio measurement set forth below.

In the measurement of the expansion ratio, the difference between the specific volume (ml/g) at room temperature and the specific volume (ml/g) after heating is determined. Into a quartz beaker preheated to 700°C in an electric furnace, 1 g of the mixture as obtained above was added, immediately thereafter, the beaker was placed in the electric furnace, heated to 700°C, for 1 minute, and the beaker was taken out and was slowly cooled down to room temperature. Thereafter, the apparent loose specific gravity (g/ml) of the expanded material was measured, the expansion ratio was calculated as the reciprocal of the apparent loose specific gravity: the expansion ratio = 1/the apparent loose specific gravity. Note that, the same method was used in Examples and Comparative Examples set forth below.

(Example 2)

A resin molded body was obtained in the same manner as in Example 1 except that the addition of the expandable graphite was 20 parts by weight.

(Example 3)

A resin molded body was obtained in the same manner as in Example 1 except that the addition of the expandable graphite was 30 parts by weight.

(Example 4)

A resin molded body was obtained in the same manner as in Example 1 except that the addition of the expandable graphite was 100 parts by weight.

(Example 5)

A resin molded body was obtained in the same manner as in Example 1 except that the addition of the expandable graphite was 200 parts by weight.

(Example 6)

A resin molded body was obtained in the same manner as in Example 1 except that the addition of the expandable graphite was 300 parts by weight.

(Example 7)

A resin molded body was obtained in the same manner as in Example 3 except that a product having an expansion ratio of 80 ml/g and a volume mean particle size of 30 μm (trade name "EXP-100S" manufactured by Fujikokuen Co., Ltd.) was used as an expandable graphite.

(Example 8)

A resin molded body was obtained in the same manner as in Example 3 except that a product having an expansion ratio of 400 ml/g and a volume mean particle size of 500 μm (trade name "9532400A" manufactured by Ito Graphite Co., Ltd.) was used as an expandable graphite.

(Example 9)

A resin molded body was obtained in the same manner as in Example 3 except that the addition of the plate graphite was 50 parts by weight.

(Example 10)

A resin molded body was obtained in the same manner as in Example 3 except that the addition of the plate graphite was 200 parts by weight.

(Example 11)

A resin molded body was obtained in the same manner as in Example 3 except that the addition of the plate graphite was 300 parts by weight.

(Example 12)

A resin molded body was obtained in the same manner as in Example 3 except that a crystalline graphite having a volume mean particle size of 30 μm (manufactured by Ito Graphite Co., Ltd., trade name "-300") was used.

(Example 13)

A resin molded body was obtained in the same manner as in Example 3 except that crystalline graphite having a volume mean particle size of 200 μm (trade name "XD150" manufactured by Ito Graphite Co., Ltd.) was used.

(Example 14)

A resin molded body was obtained in the same manner as in Example 3 except that a crystalline graphite having a volume mean particle size of 300 μm (trade name "CPB-80" manufactured by Chuetsu Graphite Works Co., Ltd.) was used.

(Example 15)

A resin molded body was obtained in the same manner as in Example 3 except that, instead of crystalline graphite, a flaked graphite having a volume mean particle size of 30 μm (trade name "UP-35N" manufactured by Nippon Graphite Industries, Co., Ltd.) was used as a plate graphite.

(Example 16)

A resin molded body was obtained in the same manner as in Example 3 except that, instead of crystalline graphite, a flaked graphite having a volume mean particle size of 100 μm (trade name "iGrafen-α" manufactured by ITEC Co., Ltd.) was used as a plate graphite.

(Example 17)

A resin molded body was obtained in the same manner as in Example 3 except that, instead of crystalline

graphite, a flaked graphite having a volume mean particle size of 200 μm (trade name "BSP-200AK" manufactured by Chuetsu Graphite Works Co., Ltd.) was used as a plate graphite.

(Example 18)

A resin molded body was obtained in the same manner as in Example 3 except that, instead of crystalline graphite, a flaked graphite having a volume mean particle size of 300 μm (trade name "BSP-300AK" manufactured by Chuetsu Graphite Works Co., Ltd.) was used as a plate graphite.

(Example 19)

Using LABO PLASTOMILL (manufactured by Toyo Seiki Seisaku-sho, Ltd., product number "R100"), 100 parts by weight of polypropylene (PP) as an olefin-based resin, 20 parts by weight of expandable graphite, 100 parts by weight of crystalline graphite as a plate graphite, and 10 parts by weight of halogen-based flame retardant as a flame retardant were melt-kneaded at 180°C to obtain a resin composition. The resultant resin composition was injection-molded at the resin composition temperature of 180°C and the mold temperature of 40°C, thereby obtaining a resin molded body with a length of 100 mm, a width of 100 mm, and a thickness of 2 mm. The trade name "BC10HRF" manufactured by Japan Polypropylene Corporation was used as a polypropylene. The trade name "EXP-80S220" (expansion ratio: 200 ml/g, volume mean particle size: 180 μm) manufactured by Fujikokuen Co., Ltd., was used as an expandable graphite. The trade name "CPB-100" (volume mean particle size: 100 μm) manufactured by Chuetsu Graphite Works Co., Ltd., was used as a crystalline graphite. In addition, a product containing antimony: the trade name "Fire Cut P-1590" (primary particle size: 3.5 μm) manufactured by SUZUHIRO CHEMICAL Co., Ltd was used as a halogen-based flame retardant.

(Example 20)

A resin molded body was obtained in the same manner as in Example 19 except that 20 parts by weight of halogen-based flame retardant was used.

(Example 21)

A resin molded body was obtained in the same manner as in Example 19 except that 50 parts by weight of halogen-based flame retardant was used.

(Example 22)

A resin molded body was obtained in the same manner as in Example 19 except that, instead of halogen based flame retardant, an ammonium polyphosphate (trade name "AP423" manufactured by Clariant Chemicals, primary particle size: 8 μm) as a phosphorus-based flame retardant was used.

(Example 23)

A resin molded body was obtained in the same manner as in Example 22 except that 20 parts by weight of ammonium polyphosphate (trade name "AP423" manufactured by Clariant Chemicals) as a phosphorus-based flame retardant was used.

(Example 24)

A resin molded body was obtained in the same manner as in Example 22 except that 50 parts by weight of ammonium polyphosphate (trade name "AP423" manufactured by Clariant Chemicals) as a phosphorus-based flame retardant was used.

(Example 25)

A resin molded body was obtained in the same manner as in Example 19 except that, instead of halogen-based flame retardant, aluminum hydroxide (trade name "B-325" manufactured by ALMORIX LTD., volume mean particle size: 27 μm) as a metal hydroxide was used.

(Example 26)

A resin molded body was obtained in the same manner as in Example 25, except that 20 parts by weight of aluminum hydroxide (trade name "B-325" manufactured by ALMORIX LTD., volume mean particle size: 27 μm) as a flame retardant was used.

(Example 27)

A resin molded body was obtained in the same manner as in Example 25, except that 50 parts by weight of aluminum hydroxide (trade name "B-325" manufactured by ALMORIX LTD., volume mean particle size: 27 μm) as a flame retardant was used.

(Example 28)

A resin molded body was obtained in the same manner as in Example 20 except that, instead of halogen-based flame retardant, alumina (trade name "DAM-03" manufactured by Denka Company Limited, volume mean particle size: 4 μm) as an inorganic filler was used.

(Example 29)

A resin molded body was obtained in the same manner as in Example 20 except that, instead of halogen-based flame retardant, calcium carbonate (trade name "μpowder 3S" manufactured by Shiraishi Calcium Kaisha Ltd., volume mean particle size: 1 μm) as an inorganic filler was used.

(Example 30)

A resin molded body was obtained in the same manner as in Example 20 except that, instead of halogen-based flame retardant, carbon black (trade name "EC200L" manufactured by Lion Corporation, primary particle size: 40 nm) as an inorganic filler was used.

(Example 31)

A resin molded body was obtained in the same manner as in Example 22 except that 10 parts by weight of alumina (trade name "DAM-03" manufactured by Denka Company Limited, volume mean particle size: 4 μm) as an inorganic filler was further added.

(Example 32)

A resin molded body was obtained in the same manner as in Example 22 except that 10 parts by weight of calcium carbonate (trade name "μpowder 3S" manufactured by Shiraishi Calcium Kaisha Ltd., volume mean particle size: 1 μm) as an inorganic filler was further added.

(Example 33)

A resin molded body was obtained in the same manner as in Example 22 except that 10 parts by weight of carbon black (trade name "EC200L" manufactured by Lion Corporation, primary particle size: 40 nm) as an inorganic filler was further added.

(Example 34)

A resin molded body was obtained in the same manner as in Example 22 except that 10 parts by weight of glass fiber (trade name "HP3273" manufactured by Nippon Electric Glass Co., Ltd., fiber diameter: 13 μm, fiber length: 4.5 mm) was further added.

(Example 35)

A resin molded body was obtained in the same manner as in Example 22 except that 50 parts by weight of glass fiber (trade name "HP3273" manufactured by Nippon Electric Glass Co., Ltd., fiber diameter 13 μm, fiber length:

4.5 mm) was further added.

(Example 36)

A resin molded body was obtained in the same manner as in Example 22 except that 100 parts by weight of glass fiber (trade name "HP3273" manufactured by Nippon Electric Glass Co., Ltd., fiber diameter 13 μm, fiber length: 4.5 mm) was further added.

(Example 37)

A resin molded body was obtained in the same manner as in Example 2 except that, instead of polypropylene (PP), polyethylene (PE, trade name "2208J" manufactured by Prime Polymer Co., Ltd.) was used.

(Example 38)

A resin molded body was obtained in the same manner as in Example 2 except that, instead of polypropylene (PP), cyclic olefin copolymer (COC, trade name "5013L-10" manufactured by Polyplastics Co., Ltd.) was used.

(Comparative Example 1)

A resin molded body was obtained in the same manner as in Example 1 except that a product having an expansion ratio of 45 ml/g and a volume mean particle size of 100 μm (trade name "9532400A" manufactured by Ito Graphite Co., Ltd.) was used as an expandable graphite and that the addition of the plate graphite was 200 parts by weight.

(Comparative Example 2)

A resin molded body was obtained in the same manner as in Example 1 except that the addition of the expandable graphite was 2 parts by weight.

(Comparative Example 3)

A resin molded body was obtained in the same manner as in Example 3 except that a product having an expansion ratio of 80 ml/g and a volume mean particle size of 30 μm (trade name "EXP-100S" manufactured by Fujikokuen Co., Ltd.) was used as an expandable graphite, and that 50 parts by weight of a crystalline graphite having a volume mean particle size of 7 μm (manufactured by Ito Graphite Co., Ltd., trade name "-300") was used as a plate graphite.

(Evaluation methods)

The resultant resin molded bodies in Examples and Comparative Examples were evaluated as follows. The results are shown in Tables 1 to 4 below.

<Flame retardancy>

A test piece was prepared by cutting the resin molded body so as to have a rectangular shape with a length of 125 mm, a width of 13 mm, and a thickness of 1.5 mm in a plan view, and the flammability of the test piece (resin molded body) was evaluated according to the UL94 V testing. UL94 V testing evaluated test pieces as V0, V1, or V2, and test pieces not applicable to these ratings were indicated as "Not applicable".

<Thermal conductivity in in-plane direction (W/(m·K))>

Thermal conductivity in the in-plane direction (in-plane thermal conductivity) was measured by using the product number "Xenon flash laser analyzer LFA467 HyperFlash" manufactured by NETZSCH Japan K.K. Specifically, a measurement sample having a size of a length of 10 mm × a width of 2 mm × a thickness of 2 mm was prepared by punching out from the resin molded body with a length of 100 mm × a width of 100 mm × a thickness of 2 mm, which was molded by the methods described in Examples and Comparative Examples. The measurement sample was placed into a holder in such a direction that allows the measurement of the in-plane thermal conductivity, and then its thermal diffusivity was measured at 30°C. The thermal conductivity was calculated according to the following equation (1).

Thermal conductivity (W/(m·K)) = specific gravity ($g/cm^3$) × specific heat (J/g K) × thermal diffusivity ($mm^2/s$)... Equation (1)

[Table 1]

| | | | Example 1 | Example 2 | Example 3 | Example 4 | Example 5 | Example 6 | Example 7 | Example 8 | Example 9 | Example 10 |
|---|---|---|---|---|---|---|---|---|---|---|---|---|
| Olefine-based resin | | Type | PP | PP | PP | PP | PP | PP | PP | PP | PP | PP |
| | | Content (parts by weight) | 100 | 100 | 100 | 100 | 100 | 100 | 100 | 100 | 100 | 100 |
| Expandable graphite | | Expansion ratio (ml/g) | 200 | 200 | 200 | 200 | 200 | 200 | 80 | 400 | 200 | 200 |
| | | Volume mean particle size (μm) | 180 | 180 | 180 | 180 | 180 | 180 | 30 | 500 | 180 | 180 |
| | | Content (parts by weight) | 10 | 20 | 30 | 100 | 200 | 300 | 30 | 30 | 30 | 30 |
| Plate graphite | Crystalline graphite (Prior to kneading) | Content (parts by weight) | 100 | 100 | 100 | 100 | 100 | 100 | 100 | 100 | 50 | 200 |
| | | Volume mean particle size (μm) | 100 | 100 | 100 | 100 | 100 | 100 | 100 | 100 | 100 | 100 |
| | Flaked graphite (Prior to kneading) | Content (parts by weight) | - | - | - | - | - | - | - | - | - | - |
| | | Volume mean particle size (μm) | - | - | - | - | - | - | - | - | - | - |
| Expansion ratio of mixture of expandable graphite and plate graphite (ml/g) | | | 20 | 30 | 50 | 90 | 130 | 160 | 20 | 70 | 70 | 50 |

(continued)

| | | | Example 1 | Example 2 | Example 3 | Example 4 | Example 5 | Example 6 | Example 7 | Example 8 | Example 9 | Example 10 |
|---|---|---|---|---|---|---|---|---|---|---|---|---|
| Volume mean particle size of mixture of expandable graphite and plate graphite (μm) | | | 100 | 110 | 110 | 120 | 140 | 160 | 60 | 150 | 130 | 120 |
| Total content of expandable graphite and plate graphite (parts by weight) | | | 110 | 120 | 130 | 200 | 300 | 400 | 130 | 130 | 80 | 230 |
| Content ratio of expandable graphite to plate graphite (expandable graphite/plate graphite) | | | 0.10 | 0.20 | 0.30 | 1.00 | 2.00 | 3.00 | 0.30 | 0.30 | 0.60 | 0.15 |
| Flame retardant | Halogen-based flame retardant | Content (parts by weight) | - | - | - | - | - | - | - | - | - | - |
| | | Primary particle size (μm) | - | - | - | - | - | - | - | - | - | - |
| | Phosphorus-based flame retardant | Content (parts by weight) | - | - | - | - | - | - | - | - | - | - |
| | | Primary particle size (μm) | - | - | - | - | - | - | - | - | - | - |
| | Metal hydroxide | Content (parts by weight) | - | - | - | - | - | - | - | - | - | - |
| | | Volume mean particle size (μm) | - | - | - | - | - | - | - | - | - | - |

(continued)

| | | | Example 1 | Example 2 | Example 3 | Example 4 | Example 5 | Example 6 | Example 7 | Example 8 | Example 9 | Example 10 |
|---|---|---|---|---|---|---|---|---|---|---|---|---|
| Inorganic filler | Alumina | Content (parts by weight) | - | - | - | - | - | - | - | - | - | - |
| | | Volume mean particle size (μm) | - | - | - | - | - | - | - | - | - | - |
| | Calcium hydroxide | Content (parts by weight) | - | - | - | - | - | - | - | - | - | - |
| | | Volume mean particle size (μm) | - | - | - | - | - | - | - | - | - | - |
| | Carbon black | Content (parts by weight) | - | - | - | - | - | - | - | - | - | - |
| | | Primary particle size (μm) | - | - | - | - | - | - | - | - | - | - |
| Fiber-based filler | Glass fiber | Content (parts by weight) | - | - | - | - | - | - | - | - | - | - |
| | | Fiber length (mm) | - | - | - | - | - | - | - | - | - | - |
| UL94 V determination | | | V-1 | V-1 | V-0 | V-0 | V-0 | V-0 | V-1 | V-0 | V-1 | V-0 |
| Thermal conductivity in in-plane direction (W/(m·K)) | | | 6.5 | 7. 1 | 8.2 | 12.3 | 15.4 | 20.4 | 6.3 | 8. 1 | 3.9 | 17.1 |

[Table 2]

| | | | Example 11 | Example 12 | Example 13 | Example 14 | Example 15 | Example 16 | Example 17 | Example 18 |
|---|---|---|---|---|---|---|---|---|---|---|
| Olefine-based resin | | Type | PP | PP | PP | PP | PP | PP | PP | PP |
| | | Content (parts by weight) | 100 | 100 | 100 | 100 | 100 | 100 | 100 | 100 |
| Expandable graphite | | Expansion ratio (ml/g) | 200 | 200 | 200 | 200 | 200 | 200 | 200 | 200 |
| | | Volume mean particle size (μm) | 180 | 180 | 180 | 180 | 180 | 180 | 180 | 180 |
| | | Content (parts by weight) | 30 | 30 | 30 | 30 | 30 | 30 | 30 | 30 |
| Plate graphite | Crystalline graphite (Prior to kneading) | Content (parts by weight) | 300 | 100 | 100 | 100 | - | - | - | - |
| | | Volume mean particle size (μm) | 100 | 30 | 200 | 300 | - | - | - | - |
| | Flaked graphite (Prior to kneading) | Content (parts by weight) | - | - | - | - | 100 | 100 | 100 | 100 |
| | | Volume mean particle size (μm) | - | - | - | - | 30 | 100 | 200 | 300 |
| Expansion ratio of mixture of expandable graphite and plate graphite (ml/g) | | | 30 | 60 | 40 | 35 | 60 | 50 | 40 | 35 |
| Volume mean particle size of mixture of expandable graphite and plate graphite (μm) | | | 110 | 80 | 190 | 230 | 80 | 120 | 190 | 230 |
| Total content of expandable graphite and plate graphite (parts by weight) | | | 330 | 130 | 130 | 130 | 130 | 130 | 130 | 130 |
| Content ratio of expandable graphite to plate graphite (expandable graphite/plate graphite) | | | 0.10 | 0.30 | 0.30 | 0.30 | 0.30 | 0.30 | 0.30 | 0.30 |

(continued)

| | | | Example 11 | Example 12 | Example 13 | Example 14 | Example 15 | Example 16 | Example 17 | Example 18 |
|---|---|---|---|---|---|---|---|---|---|---|
| Flame retardant | Halogen-based flame retardant | Content (parts by weight) | - | - | - | - | - | - | - | - |
| | | Primary particle size (μm) | - | - | - | - | - | - | - | - |
| | Phosphorus-based flame retardant | Content (parts by weight) | - | - | - | - | - | - | - | - |
| | | Primary particle size (μm) | - | - | - | - | - | - | - | - |
| | Metal hydroxide | Content (parts by weight) | - | - | - | - | - | - | - | - |
| | | Volume mean particle size (μm) | - | - | - | - | - | - | - | - |
| Inorganic filler | Alumina | Content (parts by weight) | - | - | - | - | - | - | - | - |
| | | Volume mean particle size (μm) | - | - | - | - | - | - | - | - |
| | Calcium hydroxide | Content (parts by weight) | - | - | - | - | - | - | - | - |
| | | Volume mean particle size (μm) | - | - | - | - | - | - | - | - |
| | Carbon black | Content (parts by weight) | - | - | - | - | - | - | - | - |
| | | Primary particle size (μm) | - | - | - | - | - | - | - | - |
| Fiber-based filler | Glass fiber | Content (parts by weight) | - | - | - | - | - | - | - | - |
| | | Fiber length (mm) | - | - | - | - | - | - | - | - |
| UL94 V determination | | | V-0 | V-1 | V-0 | V-0 | V-0 | V-0 | V-0 | V-0 |

(continued)

| | Example 11 | Example 12 | Example 13 | Example 14 | Example 15 | Example 16 | Example 17 | Example 18 |
|---|---|---|---|---|---|---|---|---|
| Thermal conductivity in in-plane direction (W/(m·K)) | 23.8 | 6.1 | 7.9 | 8.2 | 8. 1 | 10.8 | 11.3 | 12.8 |

[Table 3]

| | | | Example 19 | Example 20 | Example 21 | Example 22 | Example 23 | Example 24 | Example 25 | Example 26 | Example 27 | Example 28 | Example 29 | Example 30 |
|---|---|---|---|---|---|---|---|---|---|---|---|---|---|---|
| Olefine-based resin | | Type | PP | PP | PP | PP | PP | PP | PP | PP | PP | PP | PP | PP |
| | | Content (parts by weight) | 100 | 100 | 100 | 100 | 100 | 100 | 100 | 100 | 100 | 100 | 100 | 100 |
| Expandable graphite | | Expansion ratio (ml/g) | 200 | 200 | 200 | 200 | 200 | 200 | 200 | 200 | 200 | 200 | 200 | 200 |
| | | Volume mean particle size (μm) | 180 | 180 | 180 | 180 | 180 | 180 | 180 | 180 | 180 | 180 | 180 | 180 |
| | | Content (parts by weight) | 20 | 20 | 20 | 20 | 20 | 20 | 20 | 20 | 20 | 20 | 20 | 20 |
| Plate graphite | Crystalline graphite (Prior to kneading) | Content (parts by weight) | 100 | 100 | 100 | 100 | 100 | 100 | 100 | 100 | 100 | 100 | 100 | 100 |
| | | Volume mean particle size (μm) | 100 | 100 | 100 | 100 | 100 | 100 | 100 | 100 | 100 | 100 | 100 | 100 |
| | Flaked graphite (Prior to kneading) | Content (parts by weight) | - | - | - | - | - | - | - | - | - | - | - | - |
| | | Volume mean particle size (μm) | - | - | - | - | - | - | - | - | - | - | - | - |
| Expansion ratio of mixture of expandable graphite and plate graphite (ml/g) | | | 30 | 30 | 30 | 30 | 30 | 30 | 30 | 30 | 30 | 30 | 30 | 30 |

(continued)

| | | | Example 19 | Example 20 | Example 21 | Example 22 | Example 23 | Example 24 | Example 25 | Example 26 | Example 27 | Example 28 | Example 29 | Example 30 |
|---|---|---|---|---|---|---|---|---|---|---|---|---|---|---|
| Volume mean particle size of mixture of expandable graphite and plate graphite (μm) | | | 110 | 110 | 110 | 110 | 110 | 110 | 110 | 110 | 110 | 110 | 110 | 110 |
| Total content of expandable graphite and plate graphite (parts by weight) | | | 120 | 120 | 120 | 120 | 120 | 120 | 120 | 120 | 120 | 120 | 120 | 120 |
| Content ratio of expandable graphite to plate graphite (expandable graphite/ plate graphite) | | | 0.20 | 0.20 | 0.20 | 0.20 | 0.20 | 0.20 | 0.20 | 0.20 | 0.20 | 0.20 | 0.20 | 0.20 |
| Flame retardant | Halogen-based flame retardant | Content (parts by weight) | 10 | 20 | 50 | - | - | - | - | - | - | - | - | - |
| | | Primary particle size (μm) | 3.5 | 3.5 | 3.5 | - | - | - | - | - | - | - | - | - |
| | Phosphorus-based flame retardant | Content (parts by weight) | - | - | - | 10 | 20 | 50 | - | - | - | - | - | - |
| | | Primary particle size (μm) | - | - | - | 8 | 8 | 8 | - | - | - | - | - | - |
| | Metal hydroxide | Content (parts by weight) | - | - | - | - | - | - | 10 | 20 | 50 | - | - | - |
| | | Volume mean particle size (μm) | - | - | - | - | - | - | 27 | 27 | 27 | - | - | - |

(continued)

| | | | Example 19 | Example 20 | Example 21 | Example 22 | Example 23 | Example 24 | Example 25 | Example 26 | Example 27 | Example 28 | Example 29 | Example 30 |
|---|---|---|---|---|---|---|---|---|---|---|---|---|---|---|
| Inorganic filler | Alumina | Content (parts by weight) | - | - | - | - | - | - | - | - | - | 20 | - | - |
| | | Volume mean particle size (μm) | - | - | - | - | - | - | - | - | - | 4 | - | - |
| | Calcium carbonate | Content (parts by weight) | - | - | - | - | - | - | - | - | - | - | 20 | - |
| | | Volume mean particle size (μm) | - | - | - | - | - | - | - | - | - | - | 1 | - |
| | Carbon black | Content (parts by weight) | - | - | - | - | - | - | - | - | - | - | - | 20 |
| | | Primary particle size (μm) | - | - | - | - | - | - | - | - | - | - | - | 40 |
| Fiber-based filler | Glass fiber | Content (parts by weight) | - | - | - | - | - | - | - | - | - | - | - | - |
| | | Fiber length (mm) | - | - | - | - | - | - | - | - | - | - | - | - |
| UL94 V determination | | | V-1 | V-0 | V-0 | V-1 | V-0 | V-0 | V-1 | V-1 | V-1 | V-1 | V-1 | V-1 |
| Thermal conductivity in in-plane direction (W/(m·K)) | | | 7.5 | 7. 7 | 6.9 | 7.8 | 8.1 | 7.3 | 7.2 | 7. 7 | 6.6 | 8.1 | 8.2 | 8.5 |

[Table 4]

| | | | Example 31 | Example 32 | Example 33 | Example 34 | Example 35 | Example 36 | Example 37 | Example 38 | Comparative Example 1 | Comparative Example 2 | Comparative Example 3 |
|---|---|---|---|---|---|---|---|---|---|---|---|---|---|
| Olefine-based resin | | Type | PP | PP | PP | PP | PP | PP | PE | COC | PP | PP | PP |
| | | Content (parts by weight) | 100 | 100 | 100 | 100 | 100 | 100 | 100 | 100 | 100 | 100 | 100 |
| Expandable graphite | | Expansion ratio (ml/g) | 200 | 200 | 200 | 200 | 200 | 200 | 200 | 200 | 45 | 200 | 80 |
| | | Volume mean particle size (μm) | 180 | 180 | 180 | 180 | 180 | 180 | 180 | 180 | 100 | 180 | 30 |
| | | Content (parts by weight) | 20 | 20 | 20 | 20 | 20 | 20 | 20 | 20 | 10 | 2 | 30 |
| Plate graphite | Crystalline graphite (Prior to kneading) | Content (parts by weight) | 100 | 100 | 100 | 100 | 100 | 100 | 100 | 100 | 200 | 100 | 50 |
| | | Volume mean particle size (μm) | 100 | 100 | 100 | 100 | 100 | 100 | 100 | 100 | 100 | 100 | 7 |
| | Flaked graphite (Prior to kneading) | Content (parts by weight) | - | - | - | - | - | - | - | - | - | - | - |
| | | Volume mean particle size (μm) | - | - | - | - | - | - | - | - | - | - | - |
| Expansion ratio of mixture of expandable graphite and plate graphite (ml/g) | | | 30 | 30 | 30 | 30 | 30 | 30 | 30 | 30 | 8 | 80 | 130 |

(continued)

| | | | Example 31 | Example 32 | Example 33 | Example 34 | Example 35 | Example 36 | Example 37 | Example 38 | Comparative Example 1 | Comparative Example 2 | Comparative Example 3 |
|---|---|---|---|---|---|---|---|---|---|---|---|---|---|
| Volume mean particle size of mixture of expandable graphite and plate graphite (μm) | | | 110 | 110 | 110 | 110 | 110 | 110 | 110 | 110 | 100 | 140 | 12 |
| Total content of expandable graphite and plate graphite (parts by weight) | | | 120 | 120 | 120 | 120 | 120 | 120 | 120 | 120 | 210 | 102 | 80 |
| Content ratio of expandable graphite to plate graphite (expandable graphite/ plate graphite) | | | 0.20 | 0.20 | 0.20 | 0.20 | 0.20 | 0.20 | 0.20 | 0.20 | 0.05 | 0.02 | 0.60 |
| Flame retardant | Halogen-based flame retardant | Content (parts by weight) | - | - | - | - | - | - | - | - | - | - | - |
| | | Primary particle size (μm) | - | - | - | - | - | - | - | - | - | - | - |
| | Phosphorus-based flame retardant | Content (parts by weight) | 10 | 10 | 10 | 10 | 10 | 10 | - | - | - | - | - |
| | | Primary particle size (μm) | 8 | 8 | 8 | 8 | 8 | 8 | - | - | - | - | - |
| | Metal hydroxide | Content (parts by weight) | - | - | - | - | - | - | - | - | - | - | - |
| | | Volume mean particle size (μm) | - | - | - | - | - | - | - | - | - | - | - |

(continued)

| | | | Example 31 | Example 32 | Example 33 | Example 34 | Example 35 | Example 36 | Example 37 | Example 38 | Comparative Example 1 | Comparative Example 2 | Comparative Example 3 |
|---|---|---|---|---|---|---|---|---|---|---|---|---|---|
| Inorganic filler | Alumina | Content (parts by weight) | 10 | - | - | - | - | - | - | - | - | - | - |
| | | Volume mean particle size (μm) | 4 | - | - | - | - | - | - | - | - | - | - |
| | Calcium carbonate | Content (parts by weight) | - | 10 | - | - | - | - | - | - | - | - | - |
| | | Volume mean particle size (μm) | - | 1 | - | - | - | - | - | - | - | - | - |
| | Carbon black | Content (parts by weight) | - | | 10 | - | - | - | - | - | - | - | - |
| | | Primary particle size (μm) | - | - | 40 | - | - | - | - | - | - | - | - |
| Fiber-based filler | Glass fiber | Content (parts by weight) | - | - | - | 10 | 50 | 100 | - | - | - | - | - |
| | | Fiber length (mm) | - | - | - | 4.5 | 4.5 | 4.5 | - | | | | |
| UL94 V determination | | | V-0 | V-0 | V-0 | V-1 | V-1 | V-1 | V-1 | V-1 | Not applicable | Not applicable | V-1 |
| Thermal conductivity in in-plane direction (W/(m·K)) | | | 7.9 | 8.5 | 8.8 | 7. 1 | 6.5 | 5.1 | 6.6 | 8. 1 | 12.1 | 7.3 | 2.5 |

As is clear from Tables 1 to 4, with the resin molded bodies in Examples 1 to 38, it has been confirmed that both a high level of heat dissipation and a high level of flame retardancy are realized at the same time. In contrast, with the resin molded bodies in Comparative Examples 1 to 3, at least one of heat dissipation and flame retardancy was insufficient.

## Claims

1. A resin molded body comprising:

   an olefin-based resin; an expandable graphite; and a plate graphite different from the expandable graphite,
   an expansion ratio of the expandable graphite being 50 ml/g or more and 600 ml/g or less,
   a content of the expandable graphite being 10 parts by weight or more and 300 parts by weight or less with respect to 100 parts by weight of the olefin-based resin,
   a volume mean particle size of the plate graphite being 30 μm or more and 500 μm or less, and
   a content of the plate graphite being 10 parts by weight or more and 300 parts by weight or less with respect to 100 parts by weight of the olefin-based resin.

2. A resin molded body comprising:

   an olefin-based resin; an expandable graphite; and a plate graphite different from the expandable graphite,
   an expansion ratio of a mixture of the expandable graphite and the plate graphite being 10 ml/g or more and 500 ml/g or less,
   a volume mean particle size of the mixture of the expandable graphite and the plate graphite being 40 μm or more and 400 μm or less,
   a content of the expandable graphite being 10 parts by weight or more and 300 parts by weight or less with respect to 100 parts by weight of the olefin-based resin, and
   a content of the plate graphite being 10 parts by weight or more and 300 parts by weight or less with respect to 100 parts by weight of the olefin-based resin.

3. The resin molded body according to claim 1 or 2, wherein a total content of the expandable graphite and the plate graphite is 50 parts by weight or more and 500 parts by weight or less with respect to 100 parts by weight of the olefin-based resin.

4. The resin molded body according to any one of claims 1 to 3, wherein a content ratio of the expandable graphite to the plate graphite (the expandable graphite/the plate graphite) is 0.05 or more and 0.5 or less.

5. The resin molded body according to any one of claims 1 to 4, wherein a flame retardant rating as determined in accordance with UL94 flammability standard is V1 or higher.

6. The resin molded body according to any one of claims 1 to 5, wherein the resin molded body further comprises a flame retardant having a primary particle size of 0.001 μm or more and 40 μm or less.

7. The resin molded body according to claim 6, wherein a content of the flame retardant is 5 parts by weight or more and 100 parts by weight or less with respect to 100 parts by weight of the olefin-based resin.

8. The resin molded body according to any one of claims 1 to 7, wherein
   the resin molded body further comprises an inorganic filler different from the expandable graphite and the plate graphite, the inorganic filler having a volume mean particle size of 0.001 μm or more and 40 μm or less.

9. The resin molded body according to claim 8, wherein a content of the inorganic filler is 5 parts by weight or more and 100 parts by weight or less with respect to 100 parts by weight of the olefin-based resin.

10. The resin molded body according to any one of claims 1 to 9, wherein

    the resin molded body has a main surface, and
    a thermal conductivity in an in-plane direction along the main surface is 3 W/ (m·K) or more.

11. The resin molded body according to any one of claims 1 to 10, wherein the resin molded body is a heat-dissipating chassis, a heat-dissipating housing, or has a heat sink shape.

[FIG. 1.]

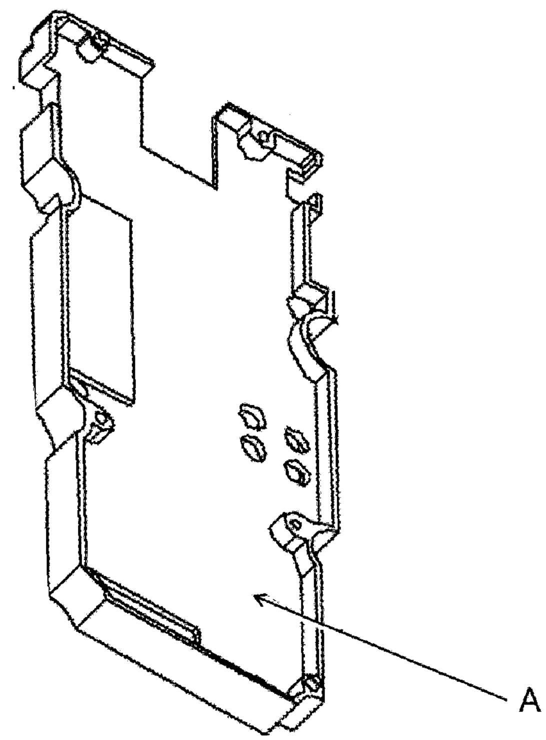


[FIG. 2.]

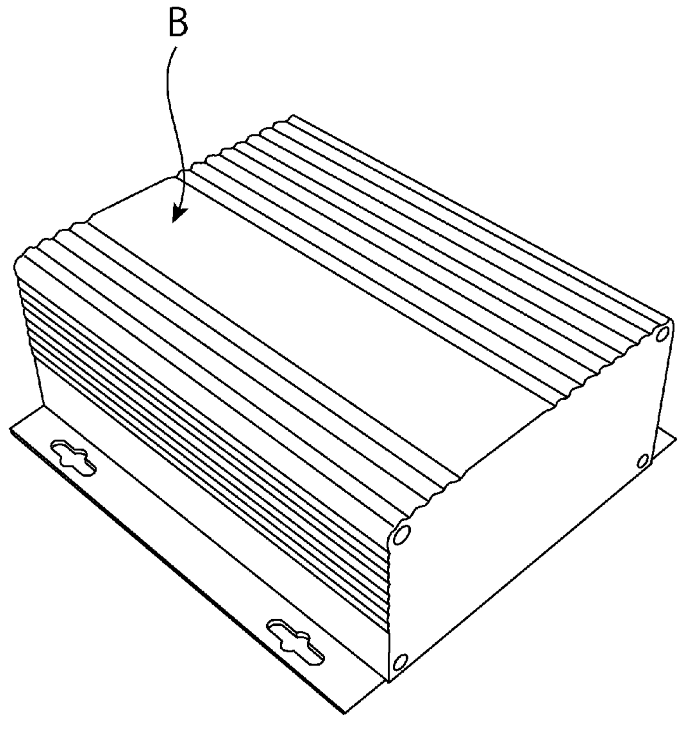

[FIG. 3.]

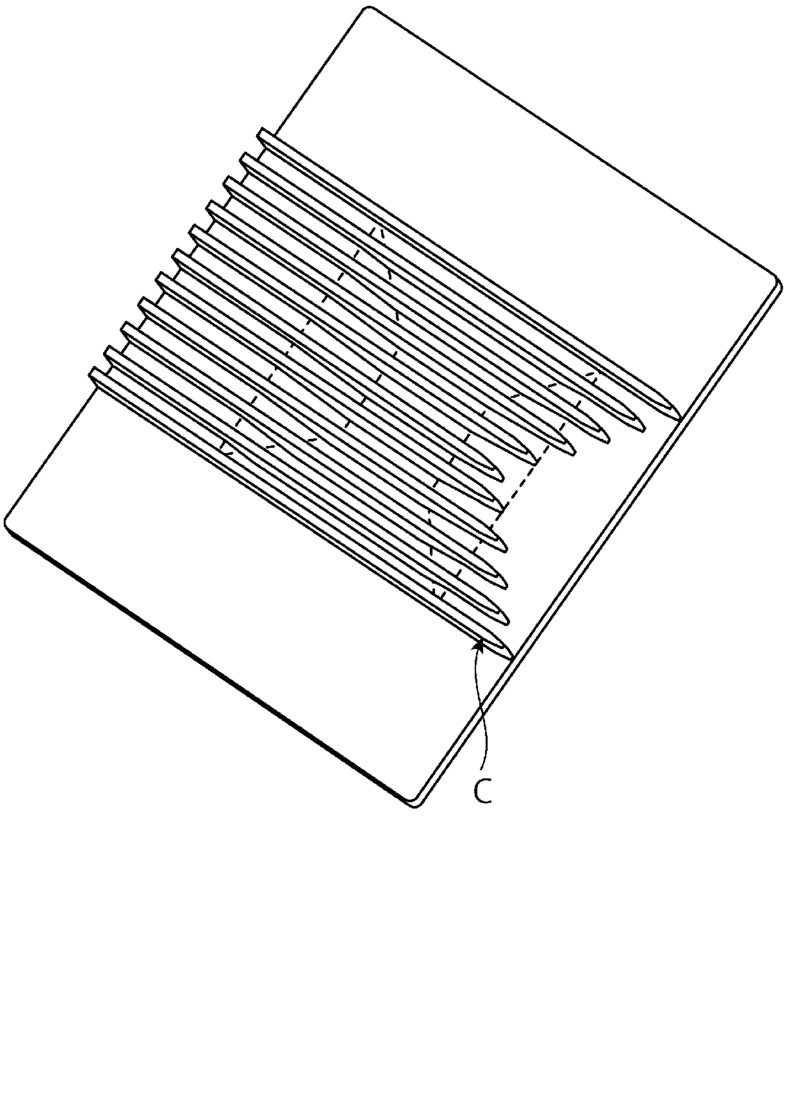

## INTERNATIONAL SEARCH REPORT

International application No. PCT/JP2020/003620

A. CLASSIFICATION OF SUBJECT MATTER
C08K 7/00(2006.01)i; C08L 23/00(2006.01)i
FI: C08L23/00; C08K7/00

According to International Patent Classification (IPC) or to both national classification and IPC

B. FIELDS SEARCHED

Minimum documentation searched (classification system followed by classification symbols)
C08K7/00; C08L23/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2006-257174 A (TORAY INDUSTRIES, INC.) 28.09.2006 (2006-09-28) claims, examples | 1-11 |
| A | JP 2006-233017 A (TORAY INDUSTRIES, INC.) 07.09.2006 (2006-09-07) paragraphs [0056]-[0058] | 1-11 |
| A | JP 2010-123564 A (HANKOOK TIRE CO., LTD.) 03.06.2010 (2010-06-03) | 1-11 |
| A | CN 109233185 A (HUIZHOU WOTE ADVANCED MAT CO., LTD.) 18.01.2019 (2019-01-18) | 1-11 |
| P, X | JP 2019-167521 A (SEIKISUI TECHNO MOLDING CO., LTD.) 03.10.2019 (2019-10-03) examples | 1-11 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 March 2020 (26.03.2020) | 07 April 2020 (07.04.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2020/003620

| Patent Documents referred in the Report | Publication Date | Patent Family | Publication Date |
|---|---|---|---|
| JP 2006-257174 A | 28 Sep. 2006 | (Family: none) | |
| JP 2006-233017 A | 07 Sep. 2006 | (Family: none) | |
| JP 2010-123564 A | 03 Jun. 2010 | US 2010/0129695 A1<br>EP 2192644 A2<br>KR 10-2010-0057411 A<br>CN 101740743 A | |
| CN 109233185 A | 18 Jan. 2019 | (Family: none) | |
| JP 2019-167521 A | 03 Oct. 2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013043949 A
- JP 2015189783 A